# EUROPEAN PATENT SPECIFICATION

(11) **EP 2 991 464 B1**
(45) Date of publication and mention of the grant of the patent: **15.04.2020**
(21) Application number: 15159536.0
(22) Date of filing: 18.03.2015
(51) Int. Cl.: F21K 9/20, F21K 9/64, H05K 3/28, F21V 31/00

(54) **LIGHT EMITTING MODULE AND LIGHTING DEVICE**
LICHTEMITTIERENDES MODUL UND BELEUCHTUNGSVORRICHTUNG
MODULE ÉLECTROLUMINESCENT ET DISPOSITIF D'ÉCLAIRAGE

(30) Priority: 29.08.2014 JP 2014175595
(43) Date of publication of application: 02.03.2016
(73) Proprietor: Toshiba Lighting & Technology Corporation, Yokosuka-shi Kanagawa 237-8510 (JP)
(72) Inventor: Hatanaka, Toshihiro, Kanagawa, 237-8510 (JP); Hino, Kiyokazu, Kanagawa, 237-8510 (JP); Shiraishi, Hiromitsu, Kanagawa, 237-8510 (JP)
(74) Representative: AWA Sweden AB

(56) References cited:
- EP-A1- 2 565 951
- US-A1- 2008 007 939
- US-A1- 2011 116 252
- US-A1- 2011 180 817
- US-A1- 2012 080 713

## Description

### FIELD

Embodiments described herein relate generally to a light emitting module and a lighting device.

### BACKGROUND

There is a lighting device having a light emitting module.

The light emitting module is provided with a board, a light emitting element, a control element, and the like.

The light emitting element and the control element are electrically connected to a wiring pattern provided on the board.

Here, the wiring pattern is made of a material which has silver as a main component in order to reduce electrical resistance. For this reason, there is a case where migration may occur due to conduction under a high humidity condition.

If an exposed portion of the wiring pattern is covered by a coating portion made of a resin or the like, the occurrence of migration can be minimized.

However, if a coating step of a resin or the like is provided separately in order to cover only the exposed portion of the wiring pattern, there is a concern that manufacturing cost may increase.

For this reason, the development of a technique for minimizing the occurrence of migration and reducing manufacturing cost is desirable.

US 2011/180817 A1 relates to a light emitting device.

US 2011/0309404 A1 relates to a light emitting device.

### BRIEF DESCRIPTION OF THE DRAWINGS

FIG. 1 is a schematic perspective view of a lighting device according to the present exemplary embodiment;
FIG. 2 is a schematic exploded perspective view of the lighting device according to the present exemplary embodiment; and
FIG. 3 is a schematic plan view of a light emitting module.

### DETAILED DESCRIPTION

According to an exemplary embodiment, there is provided a light emitting module including: a board that is provided with a wiring pattern; a light emitting element that is electrically connected to the wiring pattern; a surrounding wall member that is provided on the board via a joining portion containing a resin and surrounds the light emitting element; and a first coating portion that contains the same resin as the resin contained in the joining portion, and covers an exposed portion of the wiring pattern outside the surrounding wall member.

According to the light emitting module, the occurrence of migration can be minimized, and manufacturing cost can be reduced.

The module may further include a sealing portion that contains the same resin as the resin contained in the joining portion, and is provided inside the surrounding wall member so as to cover the light emitting element.

According to the module, reliability can be improved, and manufacturing cost can be reduced.

The module may further include: an element that is soldered to the wiring pattern outside the surrounding wall member; and a second coating portion that contains the same resin as the resin contained in the joining portion, and covers a soldered portion of the element.

According to the module, reliability can be improved, and manufacturing cost can be reduced.

According to another exemplary embodiment, there is provided a light emitting module including: a board that is provided with a wiring pattern; a light emitting element that is electrically connected to the wiring pattern; a surrounding wall member that is provided on the board via a joining portion containing a resin and surrounds the light emitting element; a film-like resistor that is electrically connected to the wiring pattern outside the surrounding wall member; a third coating portion that contains a resin and covers the film-like resistor; and a fourth coating portion that contains the same resin as the resin contained in the third coating portion, and covers an exposed portion of the wiring pattern outside the surrounding wall member.

According to the light emitting module, the occurrence of migration can be minimized, and manufacturing cost can be reduced.

The module may further include a sealing portion that contains the same resin as the resin contained in the third coating portion, and is provided inside the surrounding wall member so as to cover the light emitting element.

According to the module, reliability can be improved, and manufacturing cost can be reduced.

The module may further include: an element that is soldered to the wiring pattern outside the surrounding wall member; and a fifth coating portion that contains the same resin as the resin contained in the third coating portion, and covers a soldered portion of the element.

According to the module, reliability can be improved, and manufacturing cost can be reduced.

According to still another exemplary embodiment, there is provided a lighting device including: the light emitting module; and a main section that is provided with the light emitting module.

According to the lighting device, the occurrence of migration can be minimized, and manufacturing cost can be reduced.

A light emitting module 20 and a lighting device 1 according to the present exemplary embodiment may be used in, for example, a lighting device for a vehicle such as an automobile.

The lighting device for a vehicle may also be used in high temperature and high moisture environments such as an environmental temperature of 85°C and humidity of 85%.

For this reason, migration easily occurs.

In a board 2 used in the lighting device for a vehicle, a base 21 tends to be miniaturized, and a wiring pattern 24 also tends to become finer, in response to a demand for miniaturization. For this reason, if migration occurs, a short circuit or the like easily occurs.

As mentioned above, in the lighting device for a vehicle, preventing the occurrence of migration is also important.

There is a case where a component (for example, a packing made of rubber) containing sulfur is provided around the lighting device for a vehicle.

If there is a component containing sulfur nearby, there is a concern that a material of the wiring pattern may react with sulfur, and thus conduction may be inhibited or a short circuit may occur.

Hereinafter, a case will be exemplified in which the light emitting module 20 and the lighting device 1 according to the present exemplary embodiment are used for a vehicle.

However, the light emitting module 20 and the lighting device 1 according to the present exemplary embodiment are preferably used for a vehicle, but may be applied to other lighting devices such as indoor lighting devices.

Hereinafter, with reference to the drawings, an exemplary embodiment will be described. In the drawings, the same constituent elements are given the same reference numerals, and detailed description thereof will be omitted as appropriate.

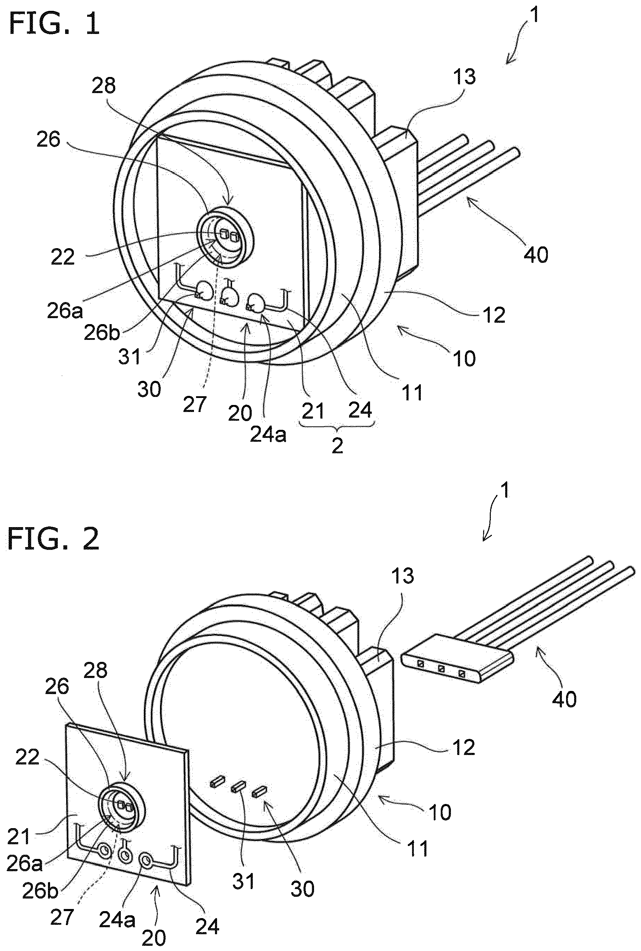

FIG. 1 is a schematic perspective view of a lighting device 1 according to the present exemplary embodiment.

FIG. 2 is a schematic exploded perspective view of the lighting device 1 according to the present exemplary embodiment.

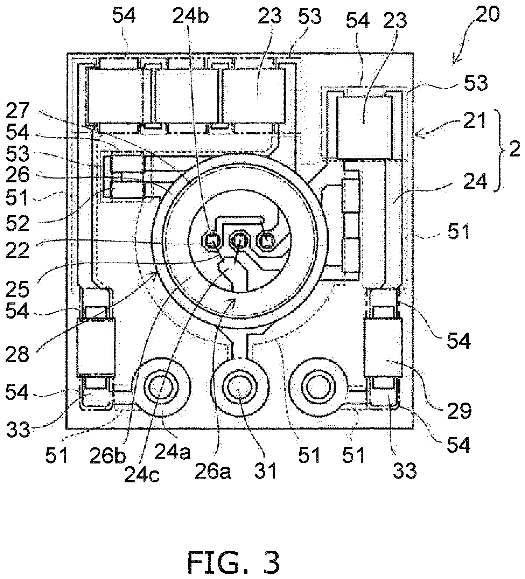

FIG. 3 is a schematic plan view of a light emitting module 20.

As illustrated in FIGS. 1 and 2, the lighting device 1 is provided with a main body section 10, a light emitting module 20, a power supply section 30, and a socket 40.

The main body section 10 is provided with a storage portion 11, a flange portion 12, and fins 13. The storage portion 11 is formed in a cylindrical shape, and protrudes from one surface of the flange portion 12. The light emitting module 20 is stored in the storage portion 11. In addition, power supply terminals 31 of the power supply section 30 protrude inside the storage portion 11.

The flange portion 12 is formed in a disc shape, and has one surface provided with the storage portion 11 and the other surface provided with the fins 13.

The plurality of fins 13 protrude from the surface of the flange portion 12. Each of the plurality of fins 13 is formed in a tabular shape, and functions as a heat dissipation fin.

The main body section 10 has a function of storing the light emitting module 20, the power supply section 30, and the like, and has a function of dissipating heat generated in the light emitting module 20 or the power supply section 30 to the outside of the lighting device 1.

For this reason, the main body section 10 may be made of a material with high thermal conductivity in consideration of dissipation of heat to the outside. For example, the main body section 10 may be made of aluminum, an aluminum alloy, a resin with high thermal conductivity, or the like. The resin with high thermal conductivity is a resin in which, for example, fibers or particles of carbon or aluminum oxide with high thermal conductivity are mixed with a resin such as PET or nylon.

In this case, a portion such as the fins 13 which dissipates heat to the outside may be made of a material with high thermal conductivity and other portions may be made of a resin or the like.

In addition, if major portions of the main body section 10 are formed by using a conductive material, in order to reliably electrically insulate the power supply terminals 31 from the portions of the main body section 10 made of a conductive material, the periphery of the power supply terminals 31 may be covered by an insulating material, and the portions made of a conductive material may be disposed in the periphery thereof. The insulating material is, for example, a resin, and is preferably a material with high thermal conductivity.

The main body section 10 may be provided with a mounting unit which is used to mount the lighting device 1 on a vehicle lighting tool (not illustrated).

As illustrated in FIG. 3, the light emitting module 20 is provided with a board 2, light emitting elements 22, a control element 23, wirings 25, a surrounding wall member 26, a sealing portion 27, a joining portion 28, a control element 29, a coating portion 51, a control element 52, a coating portion 53 (corresponding to an example of a first coating portion, a fourth coating portion, or a fifth coating portion), and a coating portion 54 (corresponding to an example of a second coating portion or a third coating portion).

The board 2 is provided with a base 21 and a wiring pattern 24.

The base 21 is provided inside the storage portion 11 of the main body section 10 and on the flange portion 12.

The base 21 is formed in a tabular shape, and is provided with the wiring pattern 24 on its surface.

The base 21 is made of ceramics such as aluminum oxide or aluminum nitride.

The base 21 may be formed of a single layer or multiple layers.

The wiring pattern 24 is provided on at least one surface of the base 21.

The wiring pattern 24 may be provided on both of the surfaces of the base 21, but is preferably provided on one surface of the base 21 in order to reduce manufacturing cost.

The wiring pattern 24 is provided with input terminals 24a.

The input terminal 24a are provided in a plurality. The input terminals 24a are electrically connected to the power supply terminals 31 of the power supply section 30. For this reason, the light emitting element 22 is electrically connected to the power supply section 30 via the wiring pattern 24.

The wiring pattern 24 is made of a material which has, for example, silver as a main component. In this case, the wiring pattern 24 is made of, for example, silver or a silver alloy. However, the wiring pattern 24 is not limited to a material having silver as a main component, and may be made of a material having, for example, copper as a main component.

The wiring pattern 24 may be formed by using, for example, a screen printing method.

The light emitting elements 22 are provided in a plurality on the wiring pattern 24 provided on the surface of the base 21.

The light emitting elements 22 may have electrodes (not illustrated) on a surface (upper surface) opposite to the surface on which the wiring pattern 24 is provided. The electrodes (not illustrated) may be provided on the surface (lower surface) on which the wiring pattern 24 is provided, and the surface (upper surface) opposite to the surface on which the wiring pattern 24 is provided, and may be provided on either of the surfaces.

The electrodes (not illustrated) provided on the lower surfaces of the light emitting elements 22 are electrically connected to mounting pads 24b provided in the wiring pattern 24, via a conductive thermosetting material such as a silver paste. The electrodes (not illustrated) provided on the light emitting elements 22 are electrically connected to wiring pads 24c provided in the wiring pattern 24, via the wirings 25.

The light emitting element 22 may be, for example, a light emitting diode, an organic light emitting diode, or a laser diode.

The upper surface which is a light emitting surface of the light emitting elements 22 is directed toward the front of the lighting device 1, and emits light toward the front of the lighting device 1.

The number, sizes, arrangement, and the like of the light emitting elements 22 are only an example and are not limited, and may be changed as appropriate depending on a size or an application of the lighting device 1.

The control element 23 is provided on the wiring pattern 24.

The control element 23 controls a current which flows through the light emitting element 22.

Since there is a variation in forward voltage characteristics of the light emitting elements 22, if an applied voltage between an anode terminal and a ground terminal is constant, a variation in brightness (luminous flux, luminance, luminous intensity, illuminance) of the light emitting elements 22 occurs. For this reason, the control element 23 performs control so that a value of a current which flows through the light emitting element 22 lies within a predetermined range and thus the brightness of the light emitting element 22 enters a predetermined range.

The control element 23 may be, for example, a resistor. The control element 23 may be, for example, a surface mounted resistor, a resistor (a resistor coated with metal oxide) with a lead wire, or a film-like resistor which is formed by using a screen printing method.

The control element 23 exemplified in FIG. 3 is a film-like resistor.

In this case, if a resistance value of the control element 23 is changed, a value of a current which flows through the light emitting element 22 can be made to enter a predetermined range.

For example, if a plurality of control elements 23 are film-like resistors, removed portions (not illustrated) are respectively formed by removing parts of the plurality of control elements 23. In addition, a resistance value of each of the plurality of control elements 23 is changed depending on a size or the like of the removed portion. In this case, if a part of the control element 23 is removed, a resistance value increases. The removal of a part of the control element 23 may be performed, for example, by irradiating the control element 23 with laser light.

The number, sizes, arrangement, and the like of the control elements 23 are only an example and are not limited, and may be changed as appropriate depending on the number, a specification, or the like of the light emitting elements 22.

The wirings 25 electrically connects the electrodes (not illustrated) provided on the light emitting elements 22 to the wiring pads 24c provided in the wiring pattern 24.

The wiring 25 may be a wiring having, for example, gold as a main component. However, the wiring 25 is not limited to a material containing gold as a main component, and may be made of a material, for example, copper as a main component or aluminum as a main component.

The wiring 25 is electrically connected to the electrode (not illustrated) provided on the upper surface of the light emitting element 22 and the wiring pad 24c provided in the wiring pattern 24, through, for example, ultrasonic welding or heat welding. The wiring 25 may be electrically connected to the electrode (not illustrated) provided on the upper surface of the light emitting element 22 and the wiring pad 24c provided in the wiring pattern 24, by using, for example, a wire bonding method.

The surrounding wall member 26 is provided on the base 21 so as to surround the plurality of light emitting elements 22. The surrounding wall member 26 has, for example, an annular shape, and the plurality of light emitting elements 22 are disposed at a center 26a of the surrounding wall member 26.

The surrounding wall member 26 may be made of, for example, a resin such as polybutylene terephthalate (PBT) or polycarbonate (PC), or ceramics.

If a resin is used as a material of the surrounding wall member 26, particles of titanium oxide or the like may be mixed with the resin so that the reflectance of light emitted from the light emitting elements 22 is increased.

A mixed material is not limited to particles of titanium oxide, and particles of a material with a high reflectance of light emitted from the light emitting elements 22 may be mixed.

The surrounding wall member 26 may be made of, for example, a white resin.

A side wall surface 26b on the center 26a of the surrounding wall member 26 is tilted. Some of light emitted from the light emitting elements 22 are reflected at the side wall surface 26b of the surrounding wall member 26 and are emitted toward the front side of the lighting device 1.

In addition, light, which is some of light emitted from the light emitting elements 22 toward the front side of the lighting device 1 and is totally reflected at an upper surface (an interface between the sealing portion 27 and the ambient air) of the sealing portion 27, is reflected at the side wall surface 26b on the center 26a side of the surrounding wall member 26, and is emitted toward the front side of the lighting device 1 again.

In other words, the surrounding wall member 26 can also be made to have a function of a reflector. A form of the surrounding wall member 26 is only an example and is not limited, and may be changed as appropriate.

The sealing portion 27 is provided at the center 26a of the surrounding wall member 26. The sealing portion 27 is provided to cover the inside of the surrounding wall member 26. In other words, the sealing portion 27 is provided inside the surrounding wall member 26 so as to cover the light emitting elements 22 and the wirings 25.

The sealing portion 27 is made of a light transmissive material.

The sealing portion 27 may be formed, for example, by filling the center 26a of the surrounding wall member 26 with a light transmissive resin. The filling with the resin may be performed by using, for example, a liquid quantitative ejecting device such as a dispenser.

If the center 26a of the surrounding wall member 26 is filled with a resin, mechanical external contact to the light emitting elements 22, and the wiring pattern 24, the wirings 25, and the like disposed at the center 26a of the surrounding wall member 26 can be prevented. In addition, moisture, sulfur, or the like can be prevented from being attached to the light emitting elements 22, and the wiring pattern 24, the wirings 25, and the like disposed at the center 26a of the surrounding wall member 26. For this reason, reliability of the lighting device 1 can be improved.

The sealing portion 27 may include phosphors. The phosphors may be, for example, yttrium-aluminum-garnet-based (YAG-based) phosphors.

For example, if the light emitting elements 22 are blue light emitting diodes, and phosphors are YAG-based phosphors, the YAG-based phosphors are excited by blue light emitted from the light emitting elements 22, and thus yellow fluorescence is radiated from the YAG-based phosphors. In addition, the blue light and the yellow light are mixed with each other, and thus white light is emitted from the lighting device 1. The kind of phosphor or the kind of light emitting element 22 is only an example and is not limited, and may be changed as appropriate so that a desired emission color can be obtained according to an application or the like of the lighting device 1.

The joining portion 28 joins the surrounding wall member 26 and the base 21 to each other.

The joining portion 28 is formed in a film shape, and is provided between the surrounding wall member 26 and the base 21. The joining portion 28 may be formed, for example, by curing a resin (adhesive).

Here, the sealing portion 27 and the joining portion 28 may be formed by using a resin.

In this case, if the same resin is used as materials of the sealing portion 27 and the joining portion 28, simultaneous curing can be performed in the same curing step.

In other words, if kinds of resins are different from each other, curing conditions are different from each other, and thus curing steps may be required to be separated. In contrast, if the same resin is used, curing conditions are the same as each other, and thus simultaneous curing can be performed in the same curing step.

For this reason, if the sealing portion 27 and the joining portion 28 are formed by using the same resin, manufacturing cost can be reduced.

In this case, a resin used in the sealing portion 27 is required to be light-transmissive. Since vibration caused by traveling is applied to the lighting device for a vehicle, a resin in which a crack hardly occurs is preferably used.

For example, the sealing portion 27 and the joining portion 28 may be formed by using a silicone resin.

The control element 29 is provided on the wiring pattern 24 via a solder portion 33. In other words, the control element 29 is soldered to the wiring pattern 24 outside the surrounding wall member 26.

The control element 29 is provided so that a reverse voltage is not applied to the light emitting elements 22 and pulse noise from a reverse direction is not applied to the light emitting elements 22.

The control element 29 may be constituted by, for example, a diode. The control element 29 may be, for example, a surface mounted diode or a diode with a lead wire.

The control element 29 exemplified in FIG. 3 is a surface mounted diode.

The control element 52 is provided on the wiring pattern 24.

The control element 52 is provided in order to detect disconnection of the light emitting diode or to prevent the light emitting diode from being wrongly turned on. The control element 52 is a pull-down resistor.

The control element 52 may be a film-like resistor which is formed by using a screen printing method.

The control element 52 may be a film-like resistor which is formed by using, for example, ruthenium oxide.

The coating portion 51 is provided in order to minimize the occurrence of migration, to prevent moisture or sulfur from being attached to the wiring pattern 24, and to ensure an electrical insulating property.

The coating portion 51 is made of a glass material.

If the glass material is used, reliability can be improved by minimizing the occurrence of migration.

Meanwhile, the coating portion 51 cannot be provided in a region where a control element is formed through screen printing, a control element is soldered, or a light emitting element is mounted.

The glass material is expensive.

For this reason, the coating portion 51 is provided to cover a part of the wiring pattern 24.

For example, the region where the control element 23 which is a film-like resistor and the control element 52 are formed is not covered by the coating portion 51.

In addition, the region where control element 29 and the power supply terminals 31 are soldered is not covered by the coating portion 51.

Further, the region (mounting region) where the light emitting elements 22 and the wirings 25 are provided is not covered by the coating portion 51.

In this case, the inside of the surrounding wall member 26 is covered by the sealing portion 27.

For this reason, although the region where the light emitting elements 22 and the wirings 25 is not covered by the coating portion 51, the wiring pattern 24 inside the surrounding wall member 26 is covered by the sealing portion 27.

As described above, the wiring pattern 24 is made of a material having, for example, silver as a main component. For this reason, if there is a portion of which the wiring pattern 24 is exposed, there is a concern that migration may occur in the exposed portion. If the migration occurs, for example, there is a concern that the facing solder portions 33 or the like may be short-circuited.

If the wiring pattern 24 is made of a material having, for example, copper as a main component, when the material is used under a high temperature condition or under an atmosphere of a large amount of sulfur components, oxidation or reaction with sulfur may be accelerated.

For this reason, in the present exemplary embodiment, the exposed portion of the wiring pattern 24 is covered by the coating portion 53.

The coating portion 53 covers the wiring pattern 24 which is not covered by the coating portion 51 outside the surrounding wall member 26.

In other words, the coating portion 53 covers the wiring pattern 24 which is exposed from the coating portion 51 outside the surrounding wall member 26.

The coating portion 53 may be formed by using, for example, a resin.

Here, silver is not contained in the control element 23 and the control element 52. In addition, silver is contained in the solder portion 33 (the region where the control element 29 is soldered), but the content of silver is small. For this reason, even if the control element 23, the control element 52, and the solder portion 33 are exposed, migration hardly occurs.

However, it is preferable for moisture, sulfur, or the like to avoid contact with the control element 23, the control element 52, and the solder portion 33.

For this reason, the coating portion 54 covers the control element 23, the control element 52, and the solder portion 33.

If the coating portion 53 is close to the coating portion 54, the coating portion 53 and the coating portion 54 may be integrally formed.

The coating portion 54 may be formed by using, for example, a resin.

Here, the coating portion 53 and the coating portion 54 may be formed by using a resin.

In this case, if the same resin is used as materials of the coating portion 53 and the coating portion 54, simultaneous curing can be performed in the same curing step.

In other words, if kinds of resins are different from each other, curing conditions are different from each other, and thus curing steps may be required to be separated. In contrast, if the same resin is used, curing conditions are the same as each other, and thus simultaneous curing can be performed in the same curing step.

For this reason, the coating portion 53 and the coating portion 54 are preferably formed by using the same resin.

As described above, the sealing portion 27 and the joining portion 28 may also be formed by using a resin.

For this reason, if the same resin is used as materials of the sealing portion 27, the joining portion 28, the coating portion 53, and the coating portion 54, simultaneous curing can be performed in the same curing step.

Therefore, the sealing portion 27, the joining portion 28, the coating portion 53, and the coating portion 54 are preferably formed by using the same resin.

For example, the sealing portion 27, the joining portion 28, the coating portion 53, and the coating portion 54 may be formed by using a silicone resin.

The sealing portion 27, the joining portion 28, the coating portion 53, and the coating portion 54 may be formed by coating a resin melted in a solvent with a liquid quantitative ejection device and by heating and curing the resin.

In this case, if the same resin is used as materials of the joining portion 28, the coating portion 53, and the coating portion 54, coating can be performed in the same coating step.

For this reason, manufacturing cost can be further reduced.

The power supply section 30 is provided with a plurality of power supply terminals 31.

The plurality of power supply terminals 31 extend through the storage portion 11 and the flange portion 12. One end of each of the plurality of power supply terminals 31 protrudes from the surface of the flange portion 12, and is electrically connected to the input terminal 24a of the wiring pattern 24. The other end of each of the plurality of power supply terminals 31 is exposed from the side of the main body section 10 opposite to the side where the base 21 is provided.

The number, arrangement, and the like of the power supply terminals 31 are only an example and are not limited, and may be changed as appropriate depending on a size or an application of the lighting device 1.

The power supply section 30 may be provided with a board (not illustrated) or elements such as a capacitor or a resistor (not illustrated). The board or the element (neither are illustrated) may be provided, for example, inside the storage portion 11 or the flange portion 12.

The socket 40 is fitted to the ends of the plurality of power supply terminals 31 exposed from the main body section 10.

The socket 40 is electrically connected to a power source (not illustrated) or the like.

For this reason, the socket 40 is fitted to the ends of the power supply terminals 31, and thus the light emitting elements 22 are electrically connected to the power source (not illustrated) or the like.

The socket 40 may be joined to the elements of the main body section 10 side by using, for example, an adhesive.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the claims.

The accompanying claims and their equivalents are intended to cover such forms or modifications as would fall within the scope of the inventions. Moreover, above-mentioned embodiments can be combined mutually and can be carried out.

## Claims

1. A light emitting module (20) comprising:
a board (2) that is provided with a wiring pattern (24);
a light emitting element (22) that is electrically connected to the wiring pattern (24); and
a surrounding wall member (26) that is provided on the board (2) via a joining portion (28) containing a resin and surrounds the light emitting element (22);
**characterized by** comprising:
a first coating portion (53) that contains the same resin as the resin contained in the joining portion (28), and covers an exposed portion of the wiring pattern (24) outside the surrounding wall member (26).

2. The module (20) according to claim 1, further comprising:
a sealing portion (27) that contains the same resin as the resin contained in the joining portion (28), and is provided inside the surrounding wall member (26) so as to cover the light emitting element (22).

3. The module (20) according to claim 1 or 2, further comprising:
an element (29) that is soldered to the wiring pattern (24) outside the surrounding wall member (26); and
a second coating portion (54) that contains the same resin as the resin contained in the joining portion (28), and covers a soldered portion of the element (29).

4. A lighting device (1) comprising:
the light emitting module (20) according to any one of claims 1 to 3; and
a main section (10) that is provided with the light emitting module (20).

5. A light emitting module (20) comprising:
a board (2) that is provided with a wiring pattern (24);
a light emitting element (22) that is electrically connected to the wiring pattern (24); and
a surrounding wall member (26) that is provided on the board (2) via a joining portion (28) containing a resin and surrounds the light emitting element (22);
**characterized by** comprising:
a film-like resistor (23) that is electrically connected to the wiring pattern (24) outside the surrounding wall member (26);
a third coating portion (54) that contains a resin and covers the film-like resistor (23); and
a fourth coating portion (53) that contains the same resin as the resin contained in the third coating portion (54), and covers an exposed portion of the wiring pattern (24) outside the surrounding wall member (26).

6. The module (20) according to claim 5, further comprising:
a sealing portion (27) that contains the same resin as the resin contained in the third coating portion (54), and is provided inside the surrounding wall member (26) so as to cover the light emitting element (22).

7. The module (20) according to claim 5 or 6, further comprising:
an element (29) that is soldered to the wiring pattern (24) outside the surrounding wall member (26); and
a fifth coating portion (53) that contains the same resin as the resin contained in the third coating portion (54), and covers a soldered portion of the element (29).

8. A lighting device (1) comprising:
the light emitting module (20) according to any one of claims 5 to 7; and
a main section (10) that is provided with the light emitting module (20).

## Patentansprüche

1. Licht emittierendes Modul (20), das Folgendes umfasst:
eine Platte (2), die mit einer Verdrahtungsstruktur (24) versehen ist;
ein Licht emittierendes Element (22), das elektrisch mit der Verdrahtungsstruktur (24) verbunden ist; und
ein umgebendes Wandelement (26), das auf der Platte (2) über einen Verbindungsabschnitt (28) bereitgestellt ist, der ein Harz enthält und das Licht emittierende Element (22) umgibt;
**dadurch gekennzeichnet, dass** es Folgendes umfasst:
einen ersten Beschichtungsabschnitt (53), der dasselbe Harz enthält wie das Harz, das in dem Verbindungsabschnitt (28) enthalten ist, und das einen exponierten Abschnitt der Verdrahtungsstruktur (24) außerhalb des umgebenden Wandelements (26) abdeckt.

2. Modul (20) nach Anspruch 1, das ferner Folgendes umfasst:
einen Dichtabschnitt (27), der das gleiche Harz enthält wie das Harz, das in dem Verbindungsabschnitt (28) enthalten ist, und innerhalb des umgebenden Wandelements (26) bereitgestellt ist, um das Licht emittierende Element (22) abzudecken.

3. Modul (20) nach Anspruch 1 oder 2, das ferner Folgendes umfasst:
ein Element (29), das an die Verdrahtungsstruktur (24) außerhalb des umgebenden Wandelements (26) gelötet ist; und
einen zweiten Beschichtungsabschnitt (54), der das gleiche Harz enthält wie das Harz, das in dem Verbindungsabschnitt (28) enthalten ist, und einen gelöteten Abschnitt des Elements (29) abdeckt.

4. Beleuchtungsvorrichtung (1), die Folgendes umfasst:
das Beleuchtungsmodul (20) nach einem der Ansprüche 1 bis 3; und
einen Hauptabschnitt (10), der mit dem Licht emittierenden Modul (20) versehen ist.

5. Licht emittierendes Modul (20), das Folgendes umfasst:
eine Platte (2), die mit einer Verdrahtungsstruktur (24) versehen ist;
ein Licht emittierendes Element (22), das mit der Verdrahtungsstruktur (24) elektrisch verbunden ist; und
ein umgebendes Wandelement (26), das auf der Platte (2) über einen Verbindungsabschnitt (28) bereitgestellt ist, der ein Harz enthält und das Licht emittierende Element (22) umgibt;
**dadurch gekennzeichnet, dass** es Folgendes umfasst:
einen folienähnlichen Widerstand (23), der mit der Verdrahtungsstruktur (24) außerhalb des umgebenden Wandelements (26) elektrisch verbunden ist;
einen dritten Beschichtungsabschnitt (54), der ein Harz enthält und den folienähnlichen Widerstand (23) abdeckt; und
einen vierten Beschichtungsabschnitt (53), der dasselbe Harz enthält wie das Harz, das in dem dritten Beschichtungsabschnitt (54) enthalten ist und einen exponierten Abschnitt der Verdrahtungsstruktur (24) außerhalb des umgebenden Wandelements (26) abdeckt.

6. Modul (20) nach Anspruch 5, das ferner Folgendes umfasst:
einen Dichtabschnitt (27), der das gleiche Harz enthält wie das Harz, das in dem dritten Beschichtungsabschnitt (54) enthalten ist, und innerhalb des umgebenden Wandelements (26) bereitgestellt ist, um das Licht emittierende Element (22) abzudecken.

7. Modul (20) nach Anspruch 5 oder 6, das ferner Folgendes umfasst:
ein Element (29), das an die Verdrahtungsstruktur (24) außerhalb des umgebenden Wandelements (26) gelötet ist; und
einen fünften Beschichtungsabschnitt (53), der das gleiche Harz enthält wie das Harz, das in dem dritten Beschichtungsabschnitt (54) enthalten ist, und einen gelöteten Abschnitt des Elements (29) abdeckt.

8. Beleuchtungsvorrichtung (1), die Folgendes umfasst:
das Licht emittierende Modul (20) nach einem der Ansprüche 5 bis 7; und
einen Hauptabschnitt (10), der mit dem Licht emittierenden Modul (20) versehen ist.

## Revendications

1. Module luminescent (20) comprenant :
une plaque (2) qui est pourvue d'un motif de câblage (24) ;
un élément luminescent (22) qui est connecté électriquement au motif de câblage (24) ; et
un élément de paroi circonvenant (26) qui est pourvu sur la plaque (2) via une portion de jonction (28) contenant une résine et entoure l'élément luminescent (22) ;
**caractérisé en ce qu'**il comprend :
une première portion de revêtement (53) qui contient la même résine que celle contenue dans la portion de jonction (28), et recouvre une portion exposée du motif de câblage (24) à l'extérieur de l'élément de paroi circonvenant (26).

2. Module (20) selon la revendication 1, comprenant en outre :
une portion d'étanchéité (27) qui contient la même résine que celle contenue dans la portion de jonction (28) et est pourvue à l'intérieur de l'élément de paroi circonvenant (26) de manière à recouvrir l'élément luminescent (22).

3. Module (20) selon la revendication 1 ou 2, comprenant en outre :
un élément (29) qui est soudé au motif de câblage (24) à l'extérieur de l'élément de paroi circonvenant (26) ; et
une deuxième portion de revêtement (54) qui contient la même résine que celle contenue dans la portion de jonction (28) et recouvre une portion soudée de l'élément (29).

4. Dispositif d'éclairage (1) comprenant :
le module luminescent (20) selon l'une quelconque des revendications 1 à 3 ; et
une section principale (10) qui est pourvue du module luminescent (20).

5. Module luminescent (20) comprenant :
une plaque (2) qui est pourvue d'un motif de câblage (24) ;
un élément luminescent (22) qui est connecté électriquement au motif de câblage (24) ; et
un élément de paroi circonvenant (26) qui est pourvu sur la plaque (2) via une portion de jonction (28) contenant une résine et entoure l'élément luminescent (22) ;
**caractérisé en ce qu'**il comprend :
une résistance en forme de film (23) qui est connectée électriquement au motif de câblage (24) à l'extérieur de l'élément de paroi circonvenant (26) ;
une troisième portion de revêtement (54) qui contient une résine et recouvre la résistance en forme de film (23) ; et
une quatrième portion de revêtement (53) qui contient la même résine que celle contenue dans la troisième portion de revêtement (54) et recouvre une portion exposée du motif de câblage (24) à l'extérieur de l'élément de paroi circonvenant (26).

6. Module (20) selon la revendication 5, comprenant en outre :
une portion d'étanchéité (27) qui contient la même résine que celle contenue dans la troisième portion de revêtement (54) et est pourvue à l'intérieur de l'élément de paroi circonvenant (26) de manière à recouvrir l'élément luminescent (22).

7. Module (20) selon la revendication 5 ou 6, comprenant en outre :
un élément (29) qui est soudé au motif de câblage (24) à l'extérieur de l'élément de paroi circonvenant (26) ; et
une cinquième portion de revêtement (53) qui contient la même résine que celle contenue dans la troisième portion de revêtement (54) et recouvre une portion soudée de l'élément (29).

8. Dispositif d'éclairage (1) comprenant :
le module luminescent (20) selon l'une quelconque des revendications 5 à 7 ; et
une section principale (10) qui est pourvue du module luminescent (20).
